# EUROPEAN PATENT APPLICATION

(11) **EP 4 489 058 A1**
(43) Date of publication of application: **08.01.2025**
(21) Application number: 22929915.1
(22) Date of filing: 26.09.2022
(51) Int. Cl.: H01L 21/318, C23C 16/455, H01L 21/31

(54) **SUBSTRATE PROCESSING METHOD, METHOD FOR PRODUCING SEMICONDUCTOR DEVICE, PROGRAM, AND SUBSTRATE PROCESSING APPARATUS**

(30) Priority: 03.03.2022 JP 2022032402
(71) Applicant: Kokusai Electric Corporation, Tokyo 101-0045 (JP)
(72) Inventor: NAGAHASHI, Tomoya, Toyama-shi, Toyama 939-2393 (JP); SUYAMA, Nagisa, Toyama-shi, Toyama 939-2393 (JP); EBATA, Shinya, Toyama-shi, Toyama 939-2393 (JP); NOHARA, Shingo, Toyama-shi, Toyama 939-2393 (JP)
(74) Representative: Bardehle Pagenberg Partnerschaft mbB Patentanwälte Rechtsanwälte
(86) International application number: PCT/JP2022/035793
(87) International publication number: WO 2023/166771

(57) **Abstract**

A substrate processing method according to the present invention comprises: (a) a step for supplying an adsorption inhibition gas to a substrate; (b) a step for supplying a starting material gas to the substrate; (c) a step for supplying a reaction gas to the substrate; and (d) a step for forming a film containing the elements contained in the starting material gas on the substrate by performing the steps (a), (b) and (c) a predetermined number of times in a state where the amount of the starting material gas supplied in the step (b) to be exposed to the substrate is set higher than the amount of the adsorption inhibition gas supplied in the step (a) to be exposed to the substrate.

## Description

### TECHNICAL FIELD

The present disclosure relates to a method of processing a substrate, a method of manufacturing a semiconductor device, a program, and a substrate processing apparatus.

### BACKGROUND

As a process of manufacturing a semiconductor device, a substrate processing process of supplying a precursor gas or a reaction gas to a substrate to form a film on the substrate may be carried out (see, *e.g.,* Japanese patent laid-open publication No. 2014-135475).

### SUMMARY

The present disclosure provides a technique capable of improving characteristics of a film formed on a substrate.

According to some embodiments of the present disclosure, there is provided a technique including:
a) supplying an adsorption inhibition gas to a substrate;
b) supplying a precursor gas to the substrate;
c) supplying a reaction gas to the substrate; and
d) forming a film containing an element contained in the precursor gas on the substrate by performing a), b), and c) a predetermined number of times in a state where an amount of exposure of the precursor gas supplied in b) to the substrate is larger than an amount of exposure of the adsorption inhibition gas supplied in a) to the substrate.

According to the present disclosure, it is possible to provide a technique capable of improving characteristics of a film formed on a substrate.

### BRIEF DESCRIPTION OF DRAWINGS

FIG. 1 is a longitudinal sectional view schematically showing a vertical process furnace of a substrate processing apparatus according to some embodiments of the present disclosure.
FIG. 2 is a schematic cross-sectional view taken along line A-A in FIG. 1.
FIG. 3 is a schematic configuration diagram of a controller of a substrate processing apparatus according to some embodiments of the present disclosure, in which a control system of the controller is shown in a block diagram.
FIG. 4 is a diagram showing an example of a substrate processing process according to some embodiments of the present disclosure.
FIG. 5 is a graph conceptually showing a relationship between an amount of exposure of an adsorption inhibition gas to a wafer and an amount of improvement in step coverage according to some embodiments of the present disclosure.
FIG. 6 is a graph conceptually showing a relationship between an amount of exposure of an adsorption inhibition gas to a wafer and an amount of adsorption of molecules of the adsorption inhibition gas on the wafer according to some embodiments of the present disclosure.
FIG. 7 is a graph conceptually showing a relationship between an amount of exposure of a precursor gas to a wafer and an amount of adsorption of molecules of the precursor gas on the wafer according to some embodiments of the present disclosure.
FIG. 8 is a graph conceptually showing a relationship between an amount of exposure of a reaction gas to a wafer and an amount of adsorption of molecules of the reaction gas on the wafer according to some embodiments of the present disclosure.
FIG. 9 is a longitudinal sectional view schematically showing a vertical process furnace of a substrate processing apparatus according to a modification of some embodiments of the present disclosure.

### DETAILED DESCRIPTION

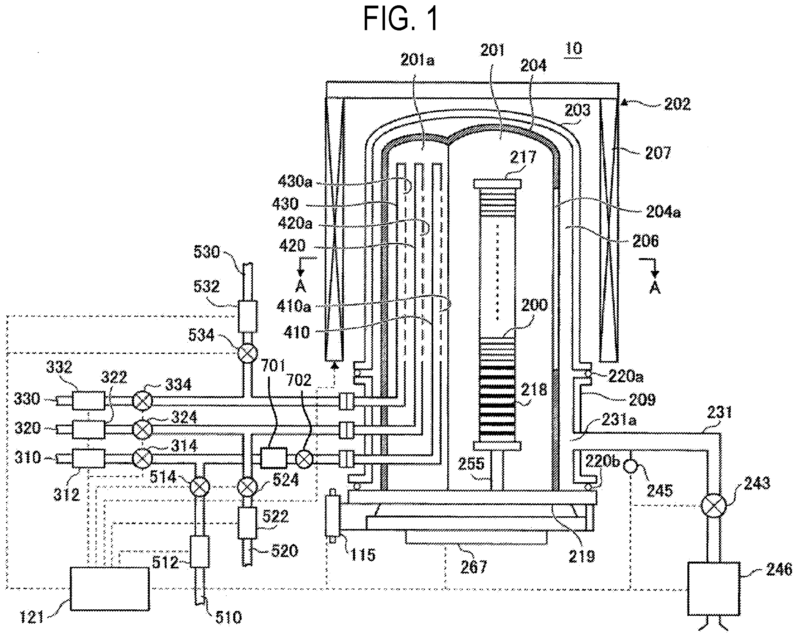

Description will now be given with reference to FIGS. 1 to 9. The drawings used in the following description are schematic, and dimensional relationships, ratios, and the like of various components shown in the drawings may not match actual ones. Further, dimensional relationships, ratios, and the like of various components among plural drawings may not match one another.

### (1) Configuration of Substrate Processing Apparatus

A substrate process apparatus 10 includes a process furnace 202 in which a heater 207 as a heating means or unit (a heating mechanism or a heating system) is provided. The heater 207 is formed in a cylindrical shape and is supported by a heater base (not shown) as a support plate so as to be vertically installed.

An outer tube 203 constituting a reaction tube (a reaction container or a process container) is disposed inside the heater 207 to be concentric with the heater 207. The outer tube 203 is made of, for example, a heat resistant material such as quartz (SiO₂) or silicon carbide (SiC) and is formed in a cylindrical shape with its upper end closed and its lower end opened. A manifold (an inlet flange) 209 is disposed below the outer tube 203 to be concentric with the outer tube 203. The manifold 209 is made of, for example, metal such as stainless steel (SUS) and is formed in a cylindrical shape with its upper and lower ends opened. An O-ring 220a serving as a seal is provided between the upper end of the manifold 209 and the outer tube 203. When the manifold 209 is supported by the heater base, the outer tube 203 is in a state of being installed vertically.

An inner tube 204 constituting the reaction container is disposed inside the outer tube 203. The inner tube 204 is made of, for example, a heat resistant material such as quartz or SiC and is formed in a cylindrical shape with its upper end closed and its lower end opened. The process container (reaction container) mainly includes the outer tube 203, the inner tube 204, and the manifold 209. A process chamber 201 is formed in a hollow cylindrical area (inside the inner tube 204) of the process container.

The process chamber 201 is configured to be capable of accommodating wafers 200 as substrates in such a state that the wafers 200 are arranged in a horizontal posture and in multiple stages along a vertical direction by a boat 217 as a support.

Nozzles 410, 420, and 430 are installed in the process chamber 201 so as to penetrate a sidewall of the manifold 209 and the inner tube 204. Gas supply pipes 310, 320, and 330 are connected to the nozzles 410, 420, and 430, respectively. However, the process furnace 202 of the embodiments of the present disclosure is not limited to the above-described shape.

Mass flow controllers (MFCs) 312, 322, and 332, which are flow rate controllers (flow rate control parts), are installed at the gas supply pipes 310, 320, and 330, respectively, sequentially from the upstream side. Further, valves 314, 324, and 334, which are opening/closing valves, are installed at the gas supply pipes 310, 320, and 330, respectively. Gas supply pipes 510, 520, and 530 configured to supply an inert gas are connected to the gas supply pipes 310, 320, and 330 at the downstream side of the valves 314, 324, and 334, respectively. MFCs 512, 522, and 532, which are flow rate controllers (flow rate control parts), and valves 514, 524, and 534, which are opening/closing valves, are installed at the gas supply pipes 510, 520, and 530, respectively, sequentially from the upstream side.

The nozzles 410, 420, and 430 are connected to tips of the gas supply pipes 310, 320, and 330, respectively. The nozzles 410, 420, and 430 are constituted as L-shaped nozzles, and their horizontal sides are installed to penetrate the sidewall of the manifold 209 and the inner tube 204. Vertical sides of the nozzles 410, 420, and 430 are installed inside a channel-shaped (groove-shaped) preliminary chamber 201a formed to protrude outward in a radial direction of the inner tube 204 and extend in the vertical direction. Further, the vertical sides of the nozzles 410, 420, and 430 are installed in the preliminary chamber 201a to extend upward (upward in an arrangement direction of the wafers 200) along an inner wall of the inner tube 204.

The nozzles 410, 420, and 430 are installed to extend from a lower region to an upper region of the process chamber 201. A plurality of gas supply holes 410a, 420a, and 430a are provided at positions facing the wafers 200 in the nozzles 410, 420, and 430, respectively. Thus, process gases are respectively supplied from the gas supply holes 410a, 420a, and 430a of the nozzles 410, 420, and 430 to the wafers 200. A plurality of gas supply holes 410a, 420a, and 430a are provided from a lower side to an upper side of the inner tube 204. Further, the gas supply holes 410a, 420a, and 430a are formed with the same aperture area. Further, the gas supply holes 410a, 420a, and 430a are arranged at the same pitch. However, the gas supply holes 410a, 420a, and 430a are not limited to the above-described shape. For example, the aperture areas of the gas supply holes 410a, 420a, and 430a may be gradually increased from the lower side to the upper side of the inner tube 204. This makes it possible to make a flow rate of a gas supplied from the gas supply holes 410a, 420a, and 430a to the wafers 200 more uniform.

The plurality of gas supply holes 410a, 420a, and 430a of the nozzles 410, 420, and 430 are provided from a lower side to an upper side of the boat 217. Therefore, the process gas supplied into the process chamber 201 from the gas supply holes 410a, 420a, and 430a of the nozzles 410, 420, and 430 is supplied to the entire region of the wafers 200 accommodated from the lower side to the upper side of the boat 217. The nozzles 410, 420, and 430 may be installed to extend from the lower region to the upper region of the process chamber 201. Specifically, the nozzles 410, 420, and 430 may be installed to extend to the vicinity of the ceiling of the boat 217.

As a process gas, a precursor gas is supplied from the gas supply pipe 310 into the process chamber 201 via the MFC 312, the valve 314, and the nozzle 410.

As a process gas, a reaction gas is supplied from the gas supply pipe 320 into the process chamber 201 via the MFC 322, the valve 324, and the nozzle 420.

As a process gas, an adsorption inhibition gas, which, unlike the reaction gas, inhibits adsorption of Group XIV elements, is supplied from the gas supply pipe 330 into the process chamber 201 via the MFC 332, the valve 334, and the nozzle 430. In the present disclosure, the adsorption inhibition gas is also referred to as an adsorption suppression gas, a reaction inhibition gas, or a surface modification gas.

As an inert gas, for example, a nitrogen (N₂) gas is supplied from the gas supply pipes 510, 520, and 530 into the process chamber 201 via the MFCs 512, 522, and 532, the valves 514, 524, and 534, and the nozzles 410, 420, and 430, respectively. Hereinafter, an example in which the N₂ gas is used as the inert gas will be described. However, as the inert gas, in addition to the N₂ gas, it may be possible to use, e.g., a rare gas such as an argon (Ar) gas, a helium (He) gas, a neon (Ne) gas, a xenon (Xe) gas, or the like.

When the precursor gas flows from the gas supply pipe 310, a precursor gas supply system (first gas supply system) mainly includes the gas supply pipe 310, the MFC 312, and the valve 314, but the nozzle 410 may be included in the precursor gas supply system. Further, when the reaction gas flows from the gas supply pipe 320, the reaction gas supply system (third gas supply system) mainly includes the gas supply pipe 320, the MFC 322, and the valve 324, but the nozzle 420 may be included in the reaction gas supply system. Further, when the adsorption inhibition gas flows from the gas supply pipe 330, the adsorption inhibition gas supply system (second gas supply system) mainly includes the gas supply pipe 330, the MFC 332, and the valve 334, but the nozzle 430 may be included in the adsorption inhibition gas supply system. Further, the precursor gas supply system, the reaction gas supply system, and the adsorption inhibition gas supply system may be referred to as a process gas supply system. Further, the nozzles 410, 420, and 430 may be included in the process gas supply system. Further, an inert gas supply system mainly includes the gas supply pipes 510, 520, and 530, the MFCs 512, 522, and 532, and the valves 514, 524, and 534.

Further, the gas supply pipe 310 may be provided with a storage 701 configured to store the process gas, and a valve 702 near the rear stage (the process chamber 201) of the storage 701.

In the embodiments, a gas is transferred into the inner tube 204 via the nozzles 410, 420, and 430 arranged in the preliminary chamber 201a in an annular vertically long space defined by the inner wall of the inner tube 204 and ends of a plurality of wafers 200. Then, the gas is ejected into the inner tube 204 from the plurality of gas supply holes 410a, 420a, and 430a provided at positions of the nozzles 410, 420, and 430, which face the wafers 200. More specifically, the process gas or the like is ejected in a direction parallel to a surface of the wafers 200 from the gas supply hole 410a of the nozzle 410, the gas supply hole 420a of the nozzle 420, and the gas supply hole 430a of the nozzle 430.

An exhaust hole (exhaust port) 204a is a through-hole formed in a sidewall of the inner tube 204 at a position facing the nozzles 410, 420, and 430. For example, the exhaust hole 204a is a slit-shaped through-hole formed elongated in the vertical direction. A gas supplied into the process chamber 201 from the gas supply holes 410a, 420a, and 430a of the nozzles 410, 420, and 430 and flowing over the surfaces of the wafers 200 flows through a gap (an exhaust passage 206) formed between the inner tube 204 and the outer tube 203 via the exhaust hole 204a. Then, the gas flowing through the exhaust passage 206 flows into an exhaust pipe 231 and is discharged to the outside of the process furnace 202.

The exhaust hole 204a is formed at a position facing the plurality of wafers 200. A gas supplied from the gas supply holes 410a, 420a, and 430a to the vicinity of the wafers 200 in the process chamber 201 flows in the horizontal direction and then flows through the exhaust passage 206 via the exhaust hole 204a. The exhaust hole 204a is not limited to the slit-shaped through-hole, but may be constituted by a plurality of holes.

The exhaust pipe 231 configured to exhaust an internal atmosphere of the process chamber 201 is connected to the exhaust hole 204a provided at the manifold 209. A pressure sensor 245, which is a pressure detector (pressure detecting part) configured to detect an internal pressure of the process chamber 201, an auto pressure controller (APC) valve 243, and a vacuum pump 246 as a vacuum-exhauster, are connected to the exhaust pipe 231 sequentially from the upstream side. The APC valve 243 can perform or stop a vacuum-exhausting operation in the process chamber 201 by opening or closing the valve while the vacuum pump 246 is actuated. Further, the APC valve 243 may regulate the internal pressure of the process chamber 201 by adjusting an opening state of the valve while the vacuum pump 246 is actuated. An exhaust system mainly includes the exhaust hole 204a, the exhaust passage 206, the exhaust pipe 231, the APC valve 243, and the pressure sensor 245. The vacuum pump 246 may be included in the exhaust system.

A seal cap 219 serving as a furnace opening lid configured to be capable of hermetically sealing a lower end opening of the manifold 209 is provided under the manifold 209. The seal cap 219 is configured to come into contact with the lower end of the manifold 209 from the lower side in the vertical direction. The seal cap 219 is made of, for example, metal such as SUS, and is formed in a disc shape. An O-ring 220b as a seal making contact with the lower end of the manifold 209 is provided at an upper surface of the seal cap 219. A rotator 267 configured to rotate the boat 217 configured to accommodate the wafers 200 is installed on a side of the seal cap 219 opposite from the process chamber 201 in. A rotary shaft 255 of the rotator 267 penetrates the seal cap 219 and is connected to the boat 217. The rotator 267 is configured to rotate the wafers 200 by rotating the boat 217. The seal cap 219 is configured to be vertically moved up or down by a boat elevator 115 as an elevator vertically installed outside the outer tube 203. The boat elevator 115 is configured to be capable of loading or unloading the boat 217 into or out of the process chamber 201 by moving the seal cap 219 up or down. The boat elevator 115 is constituted as a transporter (transport mechanism or transport system) configured to transport the boat 217 and the wafers 200 accommodated in the boat 217 into or out of the process chamber 201.

The boat 217 is configured to arrange a plurality of wafers 200, for example, 25 to 200 wafers 200, in such a state that the wafers 200 are arranged in a horizontal posture at intervals along a vertical direction with the centers of the wafers 200 aligned with one another. The boat 217 is made of, for example, a heat resistant material such as quartz or SiC. Dummy substrates 218 made of, for example, a heat resistant material such as quartz or SiC, are supported in a horizontal posture and in multiple stages at a lower side of the boat 217. This configuration makes it difficult for heat from the heater 207 to be transmitted to the seal cap 219. However, the embodiments are not limited to the above-described shape. For example, instead of providing the dummy substrates 218 at the lower side of the boat 217, a heat insulating tube constituted as a cylindrical member made of a heat resistant material such as quartz or SiC may be provided.

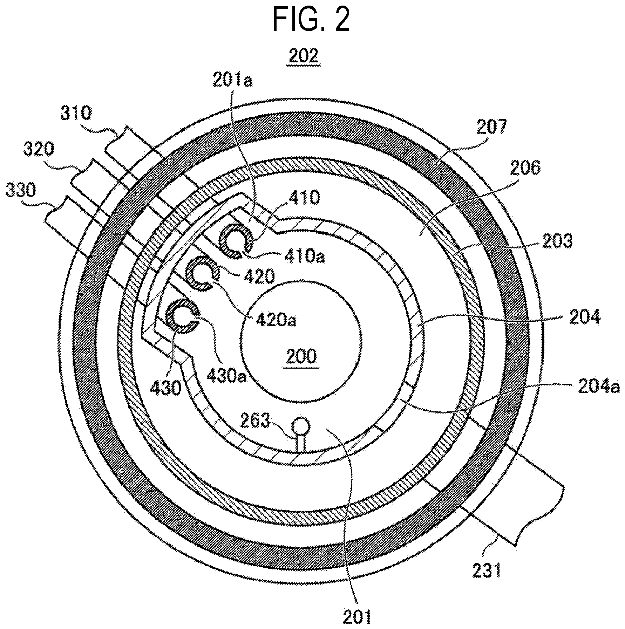

As shown in FIG. 2, a temperature sensor 263 serving as a temperature detector is installed in the inner tube 204. The substrate processing apparatus 10 is configured such that a temperature distribution inside the process chamber 201 becomes a desired temperature distribution by regulating a state of supplying electric power to the heater 207 based on temperature information detected by the temperature sensor 263. The temperature sensor 263 is formed in an L-shape, like the nozzles 410, 420, and 430, and is provided along the inner wall of the inner tube 204.

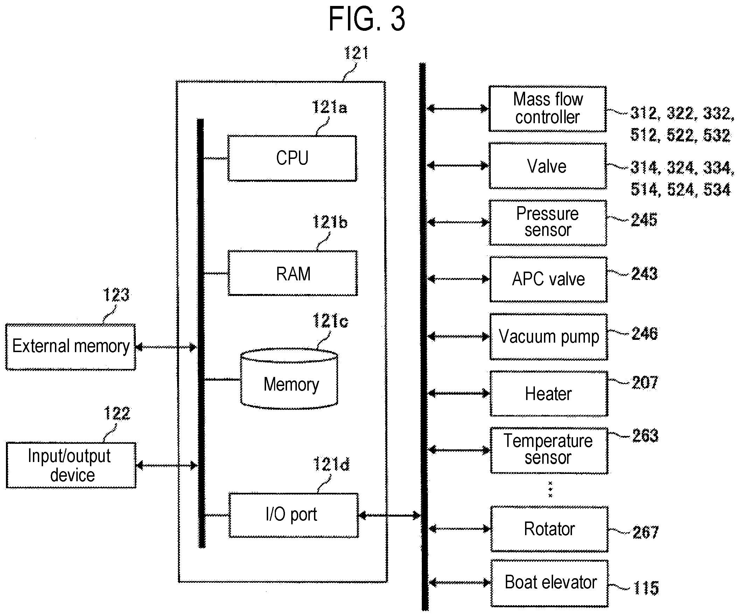

As shown in FIG. 3, a controller 121, which is a control part (control means or unit), is constituted as a computer including a central processing unit (CPU) 121a, a random access memory (RAM) 121b, a memory 121c, and an I/O port 121d. The RAM 121b, the memory 121c, and the I/O port 121d are connected to be capable of exchanging data with the CPU 121a via an internal bus. An input/output device 122 constituted by, e.g., a touch panel or the like, is connected to the controller 121.

The memory 121c is constituted by, for example, a flash memory, a hard disk drive (HDD), or the like. A control program that controls operations of a substrate processing apparatus and a process recipe in which sequences and conditions of a method of manufacturing a semiconductor device (a method of processing a substrate), which is described below, are written, are readably stored in the memory 121c. The process recipe functions as a program combined to cause the controller 121 to execute each process (each step) in the method of manufacturing the semiconductor device (the method of processing the substrate), which is described below, to obtain a predetermined result. Hereinafter, the process recipe and the control program may be generally and simply referred to as a "program." When the term "program" is used herein, it may indicate a case of including the process recipe, a case of including the control program, or a case of including a combination of the process recipe and the control program. The RAM 121b is constituted as a memory area (work area) in which a program or data read by the CPU 121a is temporarily stored.

The I/O port 121d is connected to the MFCs 312, 322, 332, 512, 522, and 532, the valves 314, 324, 334, 514, 524, 534, and 702, the pressure sensor 245, the APC valve 243, the vacuum pump 246, the heater 207, the temperature sensor 263, the rotator 267, the boat elevator 115, and the like.

The CPU 121a is configured to read and execute the control program from the memory 121c. The CPU 121a is also configured to read the process recipe from the memory 121c according to an input of an operation command from the input/output device 122. The CPU 121a is configured to be capable of controlling flow rate regulating operations of various kinds of gases by the MFCs 312, 322, 332, 512, 522, and 532, opening/closing operations of the valves 314, 324, 334, 514, 524, 534, and 702, a gas storing operation in the storage 701 by the valve 702, an opening/closing operation of the APC valve 243, a pressure regulating operation performed by the APC valve 243 based on the pressure sensor 245, a temperature regulating operation performed by the heater 207 based on the temperature sensor 263, actuating and stopping of the vacuum pump 246, an operation of rotating the boat 217 and adjusting a rotation speed of the boat 217 by the rotator 267, an operation of moving the boat 217 up or down by the boat elevator 115, an operation of accommodating the wafers 200 in the boat 217, and the like, according to contents of the read process recipe.

The controller 121 may be constituted by installing, on the computer, the aforementioned program stored in an external memory (for example, a magnetic tape, a magnetic disk such as a flexible disk or a hard disk, an optical disc such as a CD or a DVD, a magneto-optical disc such as a MO, a semiconductor memory such as a USB memory or a memory card, and the like) 123. The memory 121c and the external memory 123 are constituted as a computer-readable recording medium. Hereinafter, the memory 121c and the external memory 123 may be generally and simply referred to as a "recording medium." When the term "recording medium" is used herein, it may indicate a case of including the memory 121c, a case of including the external memory 123, or a case of including both the memory 121c and the external memory 123. The program may be provided to the computer by using a communication means or unit such as the Internet or a dedicated line, instead of using the external memory 123.

### (2) Substrate Processing Process

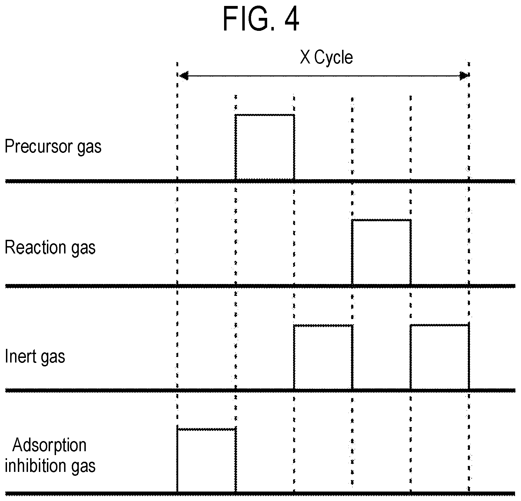

As a process of manufacturing a semiconductor device, an example of a process of forming a silicon nitride (SiN) film used as a charge trap film in a 3DNAND, for example, on a wafer 200 will be described with reference to FIG. 4. The process of forming the silicon nitride film is performed by using the process furnace 202 of the above-described substrate processing apparatus 10. Further, in the embodiments, an example will be described in which a silicon substrate (silicon wafer) whose surface is provided with a recess such as a trench or a hole is used as the wafer 200. In the following description, operations of various components constituting the substrate processing apparatus 10 is configured to be controllable by the controller 121.

A process of processing a substrate (a process of manufacturing a semiconductor device) according to the embodiments includes:
a) a step of supplying an adsorption inhibition gas into a process chamber 201 in which a wafer 200 whose surface is provided with a recess is accommodated;
b) a step of supplying a precursor gas into the process chamber 201 in which the wafer 200 is accommodated;
c) a step of supplying a reaction gas into the process chamber 201 in which the wafer 200 is accommodated; and
d) a step of forming a film containing an element contained in the precursor gas on the wafer 200 by performing a), b), and c) a predetermined number of times in a state where an amount of exposure of the precursor gas supplied in b) to the wafer 200 is larger than an amount of exposure of the adsorption inhibition gas supplied in a) to the wafer 200.

In the present disclosure, the above-described film-forming sequence may be denoted as follows for the sake of convenience. Notations similar to the following notation will be used in the description of other embodiments.

(Adsorption inhibition gas -> Precursor gas -> Reaction gas) × n

where n is a natural number (an integer of 1 or 2 or more).

When the term "wafer" is used in the present disclosure, it may refer to "a wafer itself" or " a laminated body of a wafer and certain layers or films formed on a surface of the wafer." When the phrase "a surface of a wafer" is used in the present disclosure, it may refer to "a surface of a wafer itself" or "a surface of a certain layer or film formed on a wafer." When the term "substrate" is used in the present disclosure, it may be synonymous with the term "wafer."

### (Wafer Loading)

When a plurality of wafers 200 are charged on the boat 217 (wafer charging), as shown in FIG. 1, the boat 217 supporting the plurality of wafers 200 is lifted up by the boat elevator 115 and is loaded into the process chamber 201 (boat loading). Then, the boat 217 supporting the plurality of wafers 200 is accommodated in the process container. In this state, the seal cap 219 closes a lower end opening of the outer tube 203 via the O-ring 220.

### (Pressure Regulation and Temperature Regulation)

The interior of the process chamber 201, that is, a space where the wafers 200 exist, is vacuum-exhausted by the vacuum pump 246 so that the interior of the process chamber 201 reaches a desired pressure (state of vacuum). At this time, the internal pressure of the process chamber 201 is measured by the pressure sensor 245. Then, based on the pressure information measured by the pressure sensor 245, the APC valve 243 is feedback-controlled (pressure regulation). The vacuum pump 246 is maintained in a constant operation at least until processing on the wafers 200 is completed. Further, the process chamber 201 is heated by the heater 207 so that the interior of the process chamber 201 reaches a desired temperature. At this time, based on the temperature information detected by the temperature sensor 263, a state of supplying electric power to the heater 207 is feedback-controlled such that the temperature distribution inside the process chamber 201 becomes a desired temperature distribution (temperature regulation). Heating the interior of the process chamber 201 by the heater 207 may be continuously performed at least until the processing on the wafers 200 is completed.

### [First Step]

### (Adsorption Inhibition Gas Supplying Step)

The controller 121 opens the valve 334 to allow an adsorption inhibition gas to flow through the gas supply pipe 330. The adsorption inhibition gas is supplied into the process chamber 201 from the gas supply hole 430a of the nozzle 430 after its flow rate is regulated by the MFC 332. The adsorption inhibition gas supplied into the process chamber 201 is exhausted via the exhaust pipe 231. At this time, the adsorption inhibition gas is supplied to the wafer 200. Further, at this time, the controller 121 may open the valve 534 to allow an inert gas such as a N₂ gas to flow through the gas supply pipe 530. After a flow rate of the N₂ gas flowing through the gas supply pipe 530 is regulated by the MFC 532, the N₂ gas is supplied into the process chamber 201 together with the adsorption inhibition gas. The N₂ gas supplied into the process chamber 201 is exhausted via the exhaust pipe 231. At this time, the controller 121 opens the valves 512 and 524 to allow a N₂ gas to flow through the gas supply pipes 510 and 520 so as to prevent the adsorption inhibition gas from entering the nozzles 410 and 420. The N₂ gas is supplied into the process chamber 201 via the gas supply pipes 310 and 320 and the nozzles 410 and 420 and is exhausted via the exhaust pipe 231.

At this time, the controller 121 regulates the APC valve 243 to set the internal pressure of the process chamber 201 to be within a range of, for example, 1 to 3,990 Pa, for example, 1,000 Pa. A supply flow rate of the adsorption inhibition gas controlled by the MFC 332 is set to be within a range of, for example, 0.005 to 5.0 slm. Herein, the controller 121 regulates the internal pressure of the process chamber 201 and the supply flow rate and a supply time of the adsorption inhibition gas into the process chamber 201 so that an amount of exposure of the adsorption inhibition gas to the wafer 200 becomes a first exposure amount. Further, the first exposure amount in the present disclosure is obtained, for example, by a product (partial pressure × time) of a partial pressure of the adsorption inhibition gas in the process chamber 201 and the supply time of the adsorption inhibition gas into the process chamber 201. Further, the first exposure amount is smaller than a second exposure amount, which is described below. A supply flow rate of the N₂ gas controlled by the MFCs 512, 522, and 532 is set to be within a range of, for example, 0.1 to 5.0 slm to suppress a gas containing a Group XV element from entering the respective nozzles 410, 420, and 430. At this time, a temperature of the heater 207 is set so that a temperature of the wafer 200 is within a range of, for example, 250 to 800 degrees C, specifically 600 to 700 degrees C. Further, notation of a numerical range such as "1 to 3,990 Pa" in the present disclosure means that a lower limit value and an upper limit value are included in that range. Therefore, for example, "1 to 3,990 Pa" means "1 Pa or more and 3,990 Pa or less." The same applies to other numerical ranges. Further, the first exposure amount may be a product (supply flow rate × supply time) of the supply flow rate and supply time of the adsorption inhibition gas into the process chamber 201, a product (total pressure × supply time) of a total pressure in the process chamber 201 and the supply time of the adsorption inhibition gas into the process chamber 201, or a product (partial pressure (total pressure) × supply flow rate × supply time) of the partial pressure (total pressure) in the process chamber 201 and the supply flow rate and supply time of the adsorption inhibition gas into the process chamber 201. The supply flow rate of the adsorption inhibition gas into the process chamber 201 is affected by a volume of the process chamber, a pattern of recesses formed in the wafer 200, and the like. Therefore, the first exposure amount may be the product of the partial pressure in the process chamber 201 and the supply time of the adsorption inhibition gas into the process chamber 201.

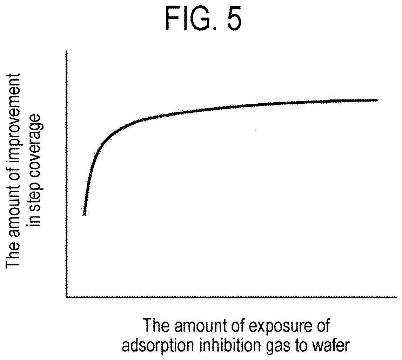

Further, the amount of exposure (first exposure amount, adsorption amount) of the adsorption inhibition gas to the wafer 200 may be set to be an amount at which an amount of improvement in step coverage of a film formed on the wafer 200 is saturated, as shown in a graph shown in FIG. 5.

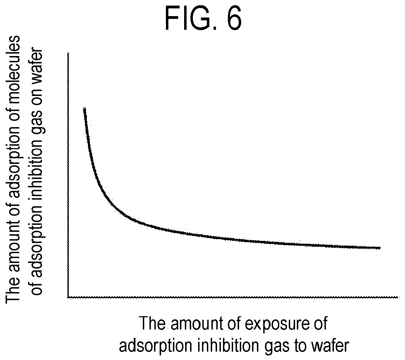

Further, as shown in a graph shown in FIG. 6, the amount of exposure (first exposure amount, adsorption amount) of the adsorption inhibition gas to the wafer 200 may be set to be an amount at which molecules of the adsorption inhibition gas are saturated and adsorbed on the wafer 200. More specifically, the amount of exposure (first exposure amount) of the adsorption inhibition gas to the wafer 200 may be set to be an amount at which, for the wafer 200 with a recess formed on its surface, the molecules of the adsorption inhibition gas is saturated and adsorbed on an opening side of the recess (an upper side of the recess). In other words, the amount of exposure of the adsorption inhibition gas to the wafer 200 may be set to be an amount at which the adsorption of the molecules of the adsorption inhibition gas to the wafer 200 is saturated. The amount of exposure of the adsorption inhibition gas to the wafer 200 may be set to be an amount at which, for the wafer 200 with the recess formed on its surface, the adsorption of the molecules of the adsorption inhibition gas to the opening side of the recess (the upper side of the recess) is saturated.

Further, for the saturation in the present disclosure the entirety of adsorbable sites of the wafer 200 may not be filled, but may be substantially saturated. That is, to improve productivity, the saturation may be a state of being not completely saturated, in other words, a state where a reaction is not completely converged. Further, in a combination of gas species and film species which exhibits a saturated curve in a region where characteristic of a reaction amount with respect to a gas supply time is larger than that in any other supply time, using a state of being not completely saturated on the saturated curve may also be referred to as saturated adsorption in the present disclosure. At least one of effects of the present disclosure may be obtained for one supply time on the saturated curve. When the supply time is set in a supply time region in which such a saturated curve is obtained, it may also be referred to as supply using saturated adsorption characteristic.

The adsorption inhibition gas supplied to the wafer 200 is, for example, a halogen element-containing gas. The halogen element-containing gas is a gas containing at least one or more Group XVII element. Examples of such a gas may include hydrogen halide gases such as a hydrogen fluoride (HF) gas, a hydrogen chloride (HCl) gas, a hydrogen bromide (HBr) gas, and a hydrogen iodide (HI) gas. Further, the adsorption inhibition gas may be a gas composed of a halogen element, for example, a fluorine (F₂) gas, a chlorine (Cl₂) gas, a bromine (Br₂) gas, and an iodine (I₂) gas. Further, the adsorption inhibition gas may be a gas containing two types of halogen elements, such as a nitrogen trifluoride (NF₃) gas and a chlorine trifluoride (ClF₃) gas. A highly polarizable gas may be used for the adsorption inhibition gas. Such a highly polarizable gas is, for example, a hydrogen halide gas, specifically a HCl gas. Molecules of such a highly polarizable gas are easily adsorbed on the wafer 200. Further, the highly polarizable gas may suppress adsorption of decomposed products produced by decomposition of the precursor gas, as well as adsorption of the precursor gas itself, which is described below. In a case where an adsorbability on the wafer 200 is not considered, a gas such as a Cl₂ may be used for the adsorption inhibition gas. Polarizability of Cl₂ is smaller than that of hydrogen halides, but a molecular size of Cl₂ is larger than that of hydrogen halides. Since the molecular size of Cl₂ is large, it exhibit an effect of inhibiting adsorption of molecules of the precursor gas and decomposed products produced by decomposition of the precursor gas. That is, an adsorption inhibitor becomes a steric hindrance.

By supplying such a gas to the wafer 200, the adsorption inhibitor is formed on the surface of the wafer 200. The adsorption inhibitor is molecules containing halogen elements or halogen elements themselves.

Further, by exposing (supplying) the adsorption inhibition gas to the wafer 200 at the first exposure amount, the molecules of the adsorption inhibition gas and some of the molecules of the adsorption inhibition gas may be adsorbed on the upper side of the recess formed on the surface of the wafer 200.

Further, the adsorption inhibition gas is not limited to the above-mentioned inorganic substances, and may be an organic-based adsorption inhibition gas. The organic-based adsorption inhibition gas is, for example, a gas containing an alkyl group (alkyl ligand). The alkyl group is, for example, a methyl group. The methyl group is electronegative and repels an electronegative precursor molecule, making it difficult to bond with the precursor molecule. For example, a methyl group (Me-) and a halogen (Cl-) contained in the precursor molecule are electronegative, making it difficult to bond with each other. Herein, Me means methyl. That is, by causing a substance containing an alkyl group to be adsorbed on a specific site on the wafer 200, it is possible to suppress a precursor gas supplied thereafter from being adsorbed on a specific site on the wafer 200. Examples of the substance containing the alkyl group may include hexamethyldisilazane (abbreviation: HMDSN), dimethylaminotrimethylsilane (abbreviation: DMATMS), trimethylsilanol (abbreviation: TMS), triethylsilanol (abbreviation: TES), etc.

### [Second Step]

### (Residual Gas Removal)

After a predetermined period of time elapses after start of supply of the adsorption inhibition gas, for example, after 1 to 600 seconds, the controller 121 closes the valve 334 of the gas supply pipe 330 to stop the supply of the adsorption inhibition gas. At this time, the controller 121 leaves the APC valve 243 of the exhaust pipe 231 open and vacuum-exhausts the interior of the process chamber 201 by using the vacuum pump 246, thereby removing the adsorption inhibition gas remaining in the process chamber 201, which remains unreacted or contributed to formation of the adsorption inhibitor, from the process chamber 201. That is, the controller 121 exhausts the internal atmosphere of the process chamber 201. By lowering the internal pressure of the process chamber 201, the gas containing the XV element remaining in the gas supply pipe 330 and the nozzle 430 may be exhausted. By exhausting the adsorption inhibition gas remaining in the gas supply pipe 330 and nozzle 430, the adsorption inhibition gas remaining in the gas supply pipe 330 and nozzle 430 may be prevented from being supplied into the process chamber 201 in a film-forming process. At this time, the controller 121 may keep the valves 514, 524, and 534 open to maintain the supply of a N₂ gas into the process chamber 201. The N₂ gas acts as a purge gas in addition to acting as a gas to suppress a gas from entering the respective nozzles 410, 420, and 430. When the N₂ gas is supplied as a purge gas into the process chamber 201, it is possible to enhance the effect of removing a gas including the adsorption inhibition gas remaining in the process chamber 201, which remains unreacted or contributed to the formation of the adsorption inhibitor, from the process chamber 201.

### [Third Step]

### (Precursor Gas Supplying Step)

Next, the controller 121 opens the valve 314 to allow a precursor gas to flow through the gas supply pipe 310. The precursor gas is supplied into the process chamber 201 from the gas supply hole 410a of the nozzle 410 after its flow rate is regulated by the MFC 312. The precursor gas supplied into the process chamber 201 is exhausted via the exhaust pipe 231. As a result, the precursor gas is supplied to the wafer 200. At this time, the controller 121 opens the valve 514 to allow an inert gas such as a N₂ gas to flow through the gas supply pipe 510. After the flow rate of the N₂ gas flowing through the gas supply pipe 510 is regulated by the MFC 512, the N₂ gas is supplied into the process chamber 201 together with the precursor gas. The N₂ gas supplied into the process chamber 201 is exhausted via the exhaust pipe 231. At this time, to prevent the precursor gas from entering the nozzles 420 and 430, the controller 121 opens the valves 524 and 534 to allow a N₂ gas to flow through the gas supply pipes 520 and 530. After the N₂ gas is supplied into the process chamber 201 via the gas supply pipes 320 and 330 and the nozzles 420 and 430, the N₂ gas is exhausted via the exhaust pipe 231.

At this time, the controller 121 regulates the APC valve 243 to set the internal pressure of the process chamber 201 to be within a range of, for example, 1 to 3,990 Pa, for example, 500 Pa. The supply flow rate of the precursor gas controlled by the MFC 312 is set to be within a range of, for example, 10 to 2,000 sccm, and specifically 10 to 1,000 sccm. Herein, a condition for supplying the precursor gas is set so that the amount of exposure of the precursor gas to the wafer 200 becomes a second exposure amount which is larger than the first exposure amount. Further, the second exposure amount in the present disclosure is, for example, a product (partial pressure × time) of the partial pressure of the precursor gas in the process chamber 201 and the supply time of the precursor gas into the process chamber 201. The supply flow rate of the N₂ gas controlled by each of the MFCs 512, 522, and 532 is set to be within a range of, for example, 0.1 to 5.0 slm. At this time, the temperature of the heater 207 is set so that the temperature of the wafer 200 is within a range of, for example, 250 to 800 degrees C, specifically 600 to 700 degrees C. Further, the second exposure amount in the present disclosure may be the product (supply flow rate × supply time) of the supply flow rate and supply time of the precursor gas into the process chamber 201, the product (total pressure×supply time) of the total pressure in the process chamber 201 and the supply time of the precursor gas into the process chamber 201, or the product (partial pressure (total pressure) × supply flow rate × supply time) of the partial pressure (total pressure) in the process chamber 201 and the supply flow rate and supply time of the precursor gas into the process chamber 201. The supply flow rate of the precursor gas into the process chamber 201 is affected by the volume of the process chamber, the pattern of recesses formed in the wafer 200, and the like. Therefore, the second exposure amount may be the product of the partial pressure in the process chamber 201 and the supply time of the precursor gas into the process chamber 201.

Further, the amount of exposure of a gas to the wafer 200 in the present disclosure may also be rephrased as an amount of adsorption of gas molecules adsorbed on the surface of the wafer 200. As described above, this amount of adsorption may be regulated by, for example, the product (partial pressure×time) of the partial pressure of the gas (adsorption inhibition gas or precursor gas) in the process chamber 201 and the supply time of the gas (adsorption inhibition gas or precursor gas) into the process chamber 201.

To make the second exposure amount (adsorption amount) in the present disclosure larger than the first exposure amount (adsorption amount), a regulation may be made by making at least one selected from the group of the partial pressure, the total pressure, the supply flow rate, and the supply time regarding the second exposure amount larger than at least one selected from the group of the partial pressure, the total pressure, the supply flow rate, and the supply time regarding the first exposure amount.

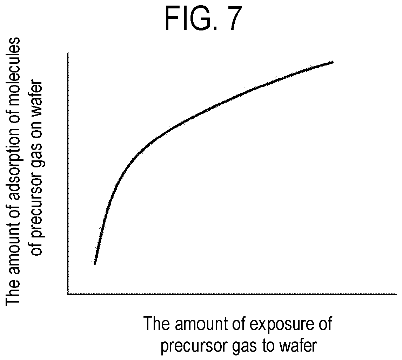

Herein, the second exposure amount (adsorption amount) of the precursor gas may be set to be an amount at which the molecule adsorption of the precursor gas on the wafer 200 is not saturated, as shown in a graph shown in FIG. 7. In other words, the second exposure amount (adsorption amount) of the precursor gas may be set to be an amount at which the molecules of the precursor gas are not saturated and adsorbed on the wafer 200.

Further, the precursor gas may be stored in the storage 701 and supplied from the storage 701 into the process chamber 201. When the precursor gas stored in the storage 701 is supplied into the process chamber 201, the supply time of the precursor gas into the process chamber 201 may be shorter than the supply time of the adsorption inhibition gas into the process chamber 201. In this case, for example, the exposure amounts (the first exposure amount and the second exposure amount) of the precursor gas and the adsorption inhibition gas are regulated so that the product of the partial pressure (total pressure) of the precursor gas in the process chamber 201 and the supply time of the precursor gas into the process chamber 201 is larger than the product of the partial pressure (total pressure) of the adsorption inhibition gas in the process chamber 201 and the supply time of the adsorption inhibition gas into the process chamber 201. Further, in the precursor gas supplying step (the third step), the precursor gas may be supplied into the process chamber multiple times as well as once. When the precursor gas is supplied into the process chamber 201 multiple times, the supply of the precursor gas into the process chamber 201 is stopped between a predetermined time and the next time. Further, when the precursor gas is supplied into the process chamber 201 multiple times, the precursor gas stored in the storage 701 may be supplied into the process chamber 201 at least once. For example, when the precursor gas is supplied into the process chamber 201 twice or more, the precursor gas stored in the storage 701 is supplied into the process chamber 201 at a first time, and the precursor gas is supplied into the process chamber 201 without storing the precursor gas in the storage 701 at a second time. Further, the supply of precursor gas into the process chamber 201 is stopped between the first time and the second time. Further, the interior of the process chamber 201 may be exhausted (depressurized) in accordance with the stop of the supply of the precursor gas into the process chamber 201, or an inert gas may be supplied into the process chamber 201 in accordance with the exhaust. Further, the supply and stop of the precursor gas into the process chamber 201 is controlled by, for example, opening or closing the valve 702.

As the precursor gas supplied to the wafer 200, for example, a silane-based gas containing Si as a main element constituting a film formed on the wafer 200 may be used. As the silane-based gas, for example, a gas containing Si and a halogen, that is, a halosilane gas, may be used. The halogen includes chlorine (Cl), fluorine (F), bromine (Br), iodine (I), and the like. As the halosilane gas, for example, a chlorosilane gas containing Si and Cl may be used.

Examples of the precursor gas may include chlorosilane gases such as a monochlorosilane (SiH₃Cl, abbreviation: MCS) gas, a dichlorosilane (SiH₂Cl₂, abbreviation: DCS) gas, a trichlorosilane (SiHCl₃, abbreviation: TCS) gas, a tetrachlorosilane (SiCl₄, abbreviation: STC) gas, a hexachlorodisilane gas (Si₂Cl₆, abbreviation: HCDS) gas, and an octachlorotrisilane (Si₃Cl₈, abbreviation: OCTS) gas. One or more of these gases may be used as the precursor gas.

In addition to the chlorosilane gases, examples of the precursor gas may include, for example, fluorosilane gases such as a tetrafluorosilane (SiF₄) gas and a difluorosilane (SiH₂F₂) gas, bromosilane gases such as a tetrabromosilane (SiBr4) gas and a dibromosilane (SiH₂Br₂) gas, and iodosilane gases such as a tetraiodosilane (SiI₄) gas and a diiodosilane (SiH₂I₂) gas. One or more of these gases may be used as the precursor gas.

In addition to these gases, for example, a gas containing Si and an amino group, that is, an aminosilane gas, may also be used as the precursor gas. The amino group is a monovalent functional group obtained by removing hydrogen (H) from ammonia, a primary amine or a secondary amine and may be expressed as -NH₂, -NHR, and -NR₂. Note that R represents an alkyl group and the two R's in -NR₂ may be the same or different.

Examples of the precursor gas may include aminosilane gases such as a tetrakis(dimethylamino)silane (Si[N(CH₃)₂]₄, abbreviation: 4DMAS) gas, a tris(dimethylamino)silane (Si[N(CH₃)₂]₃H, abbreviation: 3DMAS) gas, a bis(diethylamino)silane (Si[N(C₂H₅)₂]₂H₂, abbreviation: BDEAS) gas, a bis(tert-butylamino)silane (SiH₂[NH(C₄H₉)]₂, abbreviation: BTBAS) gas, and a (diisopropylamino)silane (SiH₃[N(C₃H₇)₂], abbreviation: DIPAS) gas. One or more of these gases may be used as the precursor gas.

In the present disclosure, an example will be described in which a HCDS gas is used as the precursor gas. When the HCDS gas is used as the precursor gas, a silicon (Si)-containing layer containing chlorine (Cl) of a predetermined thickness may be formed as a first layer on the outermost surface of the wafer 200. The Si-containing layer containing Cl may be formed by physical adsorption or chemical adsorption of molecules of the precursor gas, physical adsorption or chemical adsorption of molecules of a substance (also called a decomposition product) obtained by at least partially decomposing the molecules of the precursor gas, deposition of Si due to the thermal decomposition of the precursor gas, or the like on the outermost surface of the wafer 200. In the present disclosure, the decomposition product is also referred to as a ligand of the precursor gas or a portion of the ligand of the precursor gas. When HCDS is used as a precursor, the decomposition product is, for example, SiClₓ. In this case, x may be 2, 3, or 4. Further, the Si-containing layer containing Cl may be an adsorption layer (physical adsorption layer or chemical adsorption layer) of molecules of a chlorosilane gas or molecules of a substance obtained by partially decomposing the chlorosilane gas, or may be a Si deposition layer containing Cl. When the above-mentioned chemical adsorption layer or the above-mentioned deposition layer is formed on the outermost surface of the wafer 200, Si contained in the chlorosilane gas is adsorbed on the outermost surface of the wafer 200. In the present disclosure, the Si-containing layer containing Cl is also simply referred to as a Si-containing layer.

Further, in the present disclosure, the adsorption inhibition gas is supplied before the HCDS gas is supplied, and an adsorption inhibitor is formed on the surface of the wafer 200 by the adsorption inhibition gas. When a HCl gas is used as the adsorption inhibition gas, the adsorption inhibitor such as HCl or Cl, which is a part of HCl, is formed on the surface of the wafer 200. Such an adsorption inhibitor suppresses adsorption of molecules of the HCDS gas and adsorption of SiClₓ. That is, presence of the adsorption inhibitor may suppress adsorption of a portion of the ligand of the precursor gas. Further, adsorption of a SiClₓ with x being a specific number out of SiClₓ may be suppressed by the configuration of molecules (atoms) constituting the adsorption inhibitor.

### [Fourth Step]

### (Residual Gas Removal)

After a predetermined period of time elapses since the start of supply of the precursor gas, for example, after 1 to 60 seconds, the controller 121 closes the valve 314 of the gas supply pipe 310 to stop the supply of the precursor gas. That is, the supply time of the precursor gas to the wafer 200 is set to be within a range of, for example, 1 to 60 seconds. At this time, the controller 121 leaves the APC valve 243 of the exhaust pipe 231 open and vacuum-exhausts the interior of the process chamber 201 by using the vacuum pump 246, thereby removing the precursor gas remaining in the process chamber 201, which remains unreacted or contributed to formation of the layer, from the process chamber 201. That is, the controller 121 exhausts the internal atmosphere of the process chamber 201. At this time, the controller 121 may keep the valves 514, 524, and 534 open to maintain the supply of a N₂ gas into the process chamber 201. The N₂ gas acts as a purge gas in addition to acting as a gas to suppress a gas from entering the nozzles 410, 420, and 430. When the N₂ gas is supplied as a purge gas, it is possible to enhance an effect of removing the precursor gas remaining in the process chamber 201, which remains unreacted or contributed to formation of the layer, from the process chamber 201.

### [Fifth Step]

### (Reaction Gas Supply)

After the residual gas in the process chamber 201 is removed, the controller 121 opens the valve 324 to allow a reaction gas to flow into the gas supply pipe 320. The reaction gas is supplied into the process chamber 201 from the gas supply hole 420a of the nozzle 420 after its flow rate is regulated by the MFC 322. The reaction gas supplied into the process chamber 201 is exhausted via the exhaust pipe 231. At this time, the reaction gas is supplied to the wafer 200. Further, at this time, the controller 121 keeps the valves 514, 524, and 534 open to maintain the supply of a N₂ gas into the gas supply pipes 510, 520, and 530. The flow rate of the N₂ gas flowing through the gas supply pipes 510, 520, and 530 is regulated by the MFCs 512, 522, and 532, respectively. The N₂ gas flowing through the gas supply pipe 520 is supplied together with the reaction gas into the process chamber 201 via the gas supply pipe 320 and the nozzle 420 and then is exhausted via the exhaust pipe 231. Further, the N₂ gas flowing through the gas supply pipe 530 is supplied into the process chamber 201 via the gas supply pipe 330 and the nozzle 430 and then is exhausted via the exhaust pipe 231. Further, the N₂ gas flowing through the gas supply pipe 510 is supplied into the process chamber 201 via the gas supply pipe 310 and the nozzle 410 and then is exhausted via the exhaust pipe 231. As a result, the reaction gas is suppressed from entering the nozzle 410.

At this time, the controller 121 regulates the APC valve 243 to set the internal pressure of the process chamber 201 to be within a range of, for example, 1 to 13,300 Pa, for example, 5,000 Pa. The supply flow rate of the reaction gas controlled by the MFC 322 is set to be within a range of, for example, 1 to 50 slm, specifically 15 to 40 slm. The supply flow rates of the N₂ gas controlled by the MFCs 512, 522, and 532 are respectively set to be within a range of, for example, 0.1 to 5.0 slm.

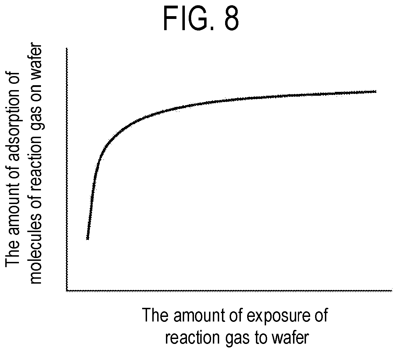

Further, specifically, as shown in a graph shown in FIG. 8, the amount of exposure (adsorption amount) of the reaction gas to the wafer 200 may be set to be an amount at which the adsorption of molecules of the reaction gas to the wafer 200 is saturated. In other words, the amount of exposure (adsorption amount) of the reaction gas to the wafer 200 may be set to be an amount at which the molecules of the reaction gas are saturated and adsorbed on the wafer 200.

As the reaction gas supplied to the wafer 200, for example, a nitrogen (N)- and hydrogen (H)-containing gas, which is a nitriding gas (nitriding agent), may be used. The N- and H-containing gas is a N-containing gas and also a H-containing gas. The N- and H-containing gas may contain a N-H bond.

Note that the term "agent" used in the present disclosure includes at least one selected from the group of a gaseous substance and a liquefied substance. The liquefied substance includes a misty substance. That is, each of a film-forming agent, a modifying agent, and an etching agent may include a gaseous substance, a liquefied substance such as a misty substance, or both of them.

As the reaction gas, for example, hydrogen nitride-based gases such as an ammonia (NH₃) gas, a diazene (N₂H₂) gas, a hydrazine (N₂H₄) gas, and a N₃H₈ gas may be used. One or more selected from the group of these gases may be used as the reaction gas.

In addition to these gases, for example, a nitrogen (N)-, carbon (C)-, and hydrogen (H)-containing gas may also be used as the reaction gas. As the N-, C- and H-containing gas, for example, an amine-based gas or an organic hydrazine-based gas may be used. The N-, C-, and H-containing gas is a N-containing gas, a C-containing gas, a H-containing gas, and also a N- and C-containing gas.

Examples of the reaction gas may include ethylamine-based gases such as a monoethylamine (C₂H₅NH₂, abbreviation: MEA) gas, a diethylamine ((C₂H₅)₂NH, abbreviation: DEA) gas, and a triethylamine ((C₂H₅)₃N, abbreviation: TEA) gas, methylamine gases such as a monomethylamine (CH₃NH₂, abbreviation: MMA) gas, a dimethylamine ((CH₃)₂NH, abbreviation: DMA) gas, and a trimethylamine ((CH₃)₃N, abbreviation: TMA) gas, organic hydrazine-based gases such as a monomethylhydrazine ((CH₃)HN₂H₂, abbreviation: MMH) gas, a dimethylhydrazine ((CH₃)₂N₂H₂, abbreviation: DMH) gas, and a trimethylhydrazine ((CH₃)₂N₂(CH₃)H, abbreviation: TMH) gas, etc. One or more of these gases may be used as the reaction gas. Note that these gases are also called amine gases.

### [Sixth Step]

### (Residual Gas Removal)

After a predetermined period of time elapses since the start of supply of the reaction gas, for example, after 1 to 1,200 seconds, the controller 121 closes the valve 324 of the gas supply pipe 320 to stop the supply of the reaction gas. Then, the reaction gas and reaction by-products remaining in the process chamber 201 which remains unreacted or contributed to formation of the layer, are removed from the process chamber 201 according to the same processing procedure as the above-described second step. That is, the controller 121 exhausts the internal atmosphere of the process chamber 201.

### (Performing Predetermined Number of Times)

By performing a cycle at least one or more times (a predetermined number of times (n times, where n is an integer of 1 or 2 or more)), the cycle including sequentially performing the above-described first to sixth steps, a film of a predetermined thickness and containing an element contained in the precursor gas is formed on the wafer 200. For example, a silicon nitride film (SiN film) may be formed on the wafer 200. The above-described cycle may be performed multiple times.

### (After-Purge and Returning to Atmospheric Pressure)

A N₂ gas is supplied by the controller 121 into the process chamber 201 from each of the gas supply pipes 510, 520, and 530. The N₂ gas supplied into the process chamber 201 is exhausted via the exhaust pipe 231. The N₂ gas acts as a purge gas, whereby the interior of the process chamber 201 is purged with the inert gas to remove a gas and reaction by-products remaining in the process chamber 201 from the process chamber 201 (after-purge). Thereafter, the internal atmosphere of the process chamber 201 is substituted with the inert gas (inert gas substitution), and the internal pressure of the process chamber 201 is returned to the atmospheric pressure (returning to atmospheric pressure).

### (Wafer Unloading)

Thereafter, the seal cap 219 is moved down by the boat elevator 115 to open the lower end of the outer tube 203. Then, the processed wafers 200 supported by the boat 217 are unloaded from the lower end of the outer tube 203 to the outside of the outer tube 203 (boat unloading). Then, the processed wafers 200 are discharged from the boat 217 (wafer discharging).

### (3) Effects of the Embodiments

According to the embodiments of the present disclosure, one or more effects set forth below may be achieved.
(a) By supplying the adsorption inhibition gas to the wafer 200, it is possible to suppress adsorption of a large amount of precursor gas on a specific site on the wafer 200. Therefore, it is possible to suppress an increase in the film thickness at the specific site on the wafer 200 and to increase the film thickness at other sites. Further, molecules of the precursor gas adsorbed on the specific site on the wafer 200 may be made to reach other sites. In other words, an amount of consumption of the precursor gas at the specific site on the wafer 200 may be reduced, and an amount of consumption of the precursor gas at other sites on the wafer 200 may be increased. Herein, the specific site is, for example, the following sites. This may be a site on the wafer 200 close to a nozzle, or in a case where a recess is formed in the wafer 200, an upper side of the recess, etc. When the specific site is the site on the wafer 200 close to the nozzle, it is possible to improve an in-plane film thickness uniformity of the wafer 200 as a film characteristic. When the specific site is the upper side of the recess, the adsorption amount (consumption amount) of the precursor gas on the upper side of the recess may be reduced, thereby increasing the adsorption amount (consumption amount) of the precursor gas on the bottom side of the recess. As a result, it is possible to improve the film thickness uniformity of a film formed on walls and bottom of the recess in the depth direction of the recess. That is, it is possible to improve the step coverage as the film characteristic.
(b) By making the exposure amount (adsorption amount) of the precursor gas larger than the exposure amount (adsorption amount) of the adsorption inhibition gas (in other words, making the exposure amount (adsorption amount) of the adsorption inhibition gas smaller than the exposure amount (adsorption amount) of the precursor gas), the molecules of the adsorption inhibition gas may be mainly adsorbed at a specific site on the wafer 200. Therefore, the adsorption amount of the precursor gas on the specific site on the wafer 200 and the adsorption amount of the precursor gas on another site on the wafer 200 may be reduced. Further, the adsorption amount of the precursor gas on other sites on the wafer 200 can be increased. As a result, a difference between the film thickness at the specific site on the wafer 200 and the film thickness at other locations on the wafer 200 may be reduced. That is, the film thickness uniformity may be improved. When a recess is formed in the wafer 200, the film thickness uniformity within the recess may be improved. In other words, the step coverage can be improved.
(c) By increasing the exposure amount of the adsorption inhibition gas, the film thickness uniformity of the wafer 200 may be improved. In particular, when a recess is formed in the wafer 200, the step coverage of the film formed within the recess may be improved. On the other hand, as the exposure amount of the adsorption inhibition gas increases, for example, as shown in the graph shown in FIG. 5, there is a phenomenon in which the improvement amount of the step coverage stops increasing after a certain value. In other words, the improvement amount of the step coverage becomes saturated. Therefore, the exposure amount of the adsorption inhibition gas may be set to be an amount at which the improvement amount of the step coverage becomes saturated.
   Such saturation of the improvement amount of the step coverage may suggest that the adsorption amount of the adsorption inhibition gas on the specific site on the wafer 200 is saturated. Therefore, the exposure amount of the adsorption inhibition gas may be set to be an amount at which the molecules of the adsorption inhibition gas are saturated and adsorbed on the wafer 200, as shown in the graph shown in FIG. 6, for example. By setting the exposure amount of the adsorption inhibition gas to an amount at which the molecules of the adsorption inhibition gas are saturated and adsorbed on the wafer 200, it is possible to obtain a maximum of the improvement amount of the step coverage. Further, the amount at which the molecules of the adsorption inhibition gas are saturated and adsorbed on the wafer 200 is set to be at least an amount at which the molecules of the adsorption inhibition gas are saturated and adsorbed on a specific site on the wafer 200. When the specific site is a recess, the adsorption amount is set to be at least an amount at which the adsorption amount of the molecules of the adsorption inhibition gas on the upper side of the recess is saturated. As a result, since the adsorption amount of the precursor gas on the upper side of the recess may be reduced and the adsorption amount of the precursor gas on the bottom side of the recess may be increased, the film thickness uniformity within the recess may be improved.
(d) Even when a gas decomposed in a gaseous phase is used as the precursor gas, the uniformity of the film formed on the wafer 200, particularly the step coverage of the recess, may be improved. The gas decomposed in the gaseous phase is, for example, a chlorosilane-based gas, specifically a HCDS gas. When the HCDS is used, for example, SiCl₂ and SiCl₄ are produced as decomposition products by decomposition of HCDS. Among these, SiCl₂ causes a CVD reaction. Due to occurrence of the CVD reaction, a relationship between the supply time of the precursor gas to the wafer 200 and the increase in the film thickness (film thickness per cycle) of the wafer 200 does not become a saturation relationship. That is, unsaturated characteristic is obtained. Note that the unsaturated characteristic means a characteristic in which the film thickness (film thickness per cycle) of the wafer 200 does not converge to a predetermined value even in a case the supply time of the precursor gas to the wafer 200 increases. In this case, for example, as shown in the graph shown in FIG. 7, the amount of exposure of the precursor gas to the wafer 200 is an amount at which the adsorption amount of molecules of the precursor gas on the wafer 200 is not saturated. In a case where the film is formed on the wafer 200 under a condition under which such unsaturated characteristic is obtained, the film thickness at a specific site on the wafer 200 increases, which may deteriorate the film thickness uniformity of the wafer 200. Regarding the characteristics of the film formed in the recess, the step coverage may deteriorate. According to the technique of the present disclosure, by supplying the adsorption inhibition gas to the wafer 200, it is possible to suppress an intermediate that causes unsaturated characteristic, such as SiCl₂, from being adsorbed on the wafer 200. As a result, the film thickness uniformity of the wafer 200 may be improved. Further, when the wafer 200 including the recess is processed, the step coverage of the film formed within the recess may be improved. Among these decomposition products, an amount of production of SiCl₂ is proportional to the supply time of the HCDS gas to the wafer 200. That is, as the supply time of the HCDS gas to the wafer 200 increases, the amount of production of SiCl₂ increases. This increase in the amount of production of SiCl₂ is due to an increase in a residence time of the HCDS molecules in the process chamber 201 as the supply time of HCDS to the wafer 200 increases. That is, it is considered that as the residence time of the HCDS molecules in the process chamber 201 increases, a time for which the HCDS molecules are heated in the process chamber 201 becomes longer, which increases the number of molecules to be thermally decomposed. To reduce the amount of production of SiCl₂ and the amount of adsorption of SiCl₂ on the wafer 200, the supply time of the HCDS gas to the wafer 200 may be reduced. To reduce the supply time of the HCDS gas to the wafer 200, the storage 701 may be used to instantaneously supply the HCDS gas to the wafer 200 (also referred to as flash supply).
(e) As shown in the graph shown in FIG. 8, the film thickness uniformity of the wafer 200 may be improved by setting the amount of exposure of the reaction gas to the wafer 200 to an amount at which the molecules of the reaction gas are saturated and adsorbed on the wafer 200. Further, the step coverage of the film formed in the recess of the wafer 200 may be improved. Further, a sufficient amount of molecules of the reaction gas may be supplied to the molecules of the precursor gas whose adsorption on the wafer 200 is suppressed by the adsorption inhibition gas. Therefore, the effect of improving the film thickness uniformity of the wafer 200, which is obtained by supplying the adsorption inhibition gas to the wafer 200, may be improved. On the other hand, in a case where the amount of exposure of the reaction gas to the wafer 200 is not sufficient, the molecules of the precursor gas adsorbed on the wafer 200 may remain on the wafer 200 without reacting with the reaction gas. For example, in a case where the molecules of the precursor gas remaining on the wafer 200 are HCDS itself, SiCl₂, which is a decomposition product, may be generated. In a case where SiCl₂ is generated, it becomes a factor that deteriorates the film thickness uniformity of the wafer 200, as described above. Further, the molecules of the precursor gas remaining on the wafer 200 may be desorbed, as they are, from the wafer 200. Further, the molecules of the precursor gas remaining on the wafer 200 may suppress the adsorption of the adsorption inhibition gas on the wafer 200 or inhibit the adsorption of the precursor gas on the wafer 200 in the next cycle.
(f) By making the amount of exposure of the adsorption inhibition gas to the wafer 200 smaller than the amount of exposure of the precursor gas to the wafer 200, the step coverage of the film formed in the recess of the wafer 200 may be made 70% or more.
(g) By making the amount of exposure of the adsorption inhibition gas to the wafer 200 smaller than the amount of exposure of the precursor gas to the wafer 200, a difference in step coverage in the depth direction of the film formed in the recess of the wafer 200 may be kept within 20%.
(h) By using an inorganic-based adsorption inhibition gas (for example, a gas containing a halogen element) as the adsorption inhibition gas, an increase in the amount of impurities caused by the adsorption inhibition gas in the film formed on the wafer 200 may be reduced. Herein, the impurities are elements other than the main elements constituting the film formed on the wafer 200. On the other hand, the molecular size of the organic-based adsorption inhibition gas is larger than that of an inorganic-based adsorption inhibition gas. Therefore, when the organic-based adsorption inhibition gas is used as the adsorption inhibition gas, an effect of the adsorption inhibition gas acting as a steric hindrance that inhibits the adsorption of the precursor gas on the wafer 200 becomes greater than when the inorganic-based adsorption inhibition gas is used as the adsorption inhibition gas.

A highly polarizable substance gas may be used as the adsorption inhibition gas. Note that polarizability in the present disclosure means molecular polarity. By using the highly polarizable substance gas as the adsorption inhibition gas, the amount of adsorption of the adsorption inhibition gas on the wafer 200 may be increased. When using a gas of a substance with low polarizability as the adsorption inhibition gas, there is a possibility that a sufficient amount of adsorption of the adsorption inhibition gas on the wafer 200 may not be obtained, but a molecular size of the substance with low polarizability may be large. When the molecular size of the substance with low polarizability is large, the molecules themselves act as a steric hindrance, so that the amount of adsorption of the precursor gas on the wafer 200 may be reduced. Herein, the substance containing a halogen element with high polarizability is, for example, a substance containing a halogen element and other elements. The other elements are, for example, elements, specifically a Group I element, other than Group XVII in the periodic table. Specifically, there are HCl, HBr, HI, and HF. The substance containing a halogen element with low polarizability is, for example, a substance composed of a halogen element. Specifically, there are Cl₂, F₂, Br₂, and I₂. Note that a highly polarizable gas (specifically, a HCl gas) is liable to be adsorbed to a NH-termination. Therefore, a gas containing a NH-group may be supplied to the wafer 200 before the adsorption inhibition gas is supplied to the wafer 200. The gas containing a NH-group includes, for example, an inorganic-based NH-group-containing gas and an organic-based NH-group-containing gas. Specifically, the inorganic-based NH-group-containing gas includes an ammonia (NH₃) gas and a hydrazine (N₂H₄) gas. The organic-based NH-group-containing gas includes a gas containing an amine group. The gas containing an amine groups includes the above-mentioned amine-based gas. When the gas containing the NH-group is used as the reaction gas, in a first cycle of forming a film on the wafer 200, a NH-termination is formed on the surface of the wafer 200 by the reaction gas supplied to the wafer 200. Since the adsorption inhibition gas for the second cycle is supplied to the wafer 200 on which the NH-termination is formed, it is also possible to maintain or improve the adsorption characteristic of the adsorption inhibition gas on the wafer 200 from the second cycle onwards. Further, before the adsorption inhibition gas is first supplied to the wafer 200, the gas containing the NH-group may be supplied to the wafer 200 to form a NH-termination on the surface of the wafer 200. In this case, a condition for supplying the gas containing the NH-group may be set so that the gas containing the NH-group is supplied to a specific site on the wafer 200. This is because in a case where the NH-termination is formed on the entire surface of the wafer 200, especially up to the bottom of the recess of the wafer 200, the adsorption inhibition gas will be adsorbed on the bottom of the recess, making it difficult to obtain the above-mentioned effects.

### <Other Embodiments of the Present Disclosure>

The embodiments of the present disclosure are specifically described above. However, the present disclosure is not limited to the above-described embodiments, and various changes may be made without departing from the gist thereof.

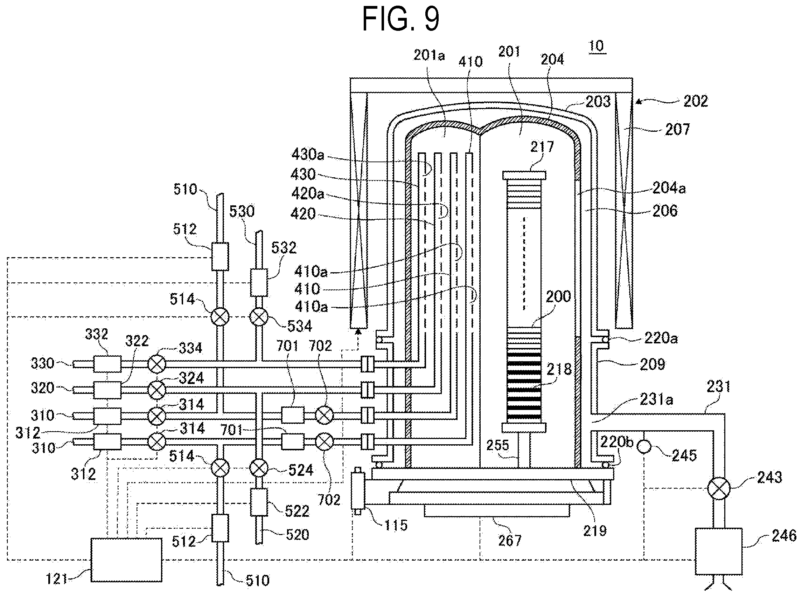

In the above-described embodiments, as shown in FIG. 1, the precursor gas is supplied into the process chamber 201 from the nozzle 410 of one gas supply pipe 310. However, for example, as in a modification shown in FIG. 9, the precursor gas may be supplied into the process chamber 201 from the nozzles 410 of the two gas supply pipes 310, respectively. Note that in FIG. 9, substantially the same elements as those described in FIG. 1 are denoted by the same reference numerals.

In the modification shown in FIG. 9, as in the above-described embodiments, as compared to the case where the precursor gas is supplied into the process chamber 201 from the nozzle 410 of one gas supply pipe 310, the supply amount of precursor gas supplied into the process chamber 201 from the nozzle 410 of each gas supply pipe 310 may be reduced. This suppresses an increase in the internal pressure within each nozzle 410, thereby suppressing a rise in the temperature of the precursor gas. As a result, the decomposition of the precursor gas (for example, a HCDS) that accompanies the temperature rise is suppressed. Therefore, the production of SiCl₂ which is a decomposition product of the precursor gas (HCDS) may be suppressed. Further, in this modification, the same effects as in the above-described embodiments may be obtained.

Further, as described above, the film-forming sequence of the above-described embodiments is as follows.

(Adsorption inhibition gas -> Precursor gas -> Reaction gas) × n

However, the film-forming sequence of the above-described embodiments may be changed as appropriate. For example, as in the following modifications (S1 to S5), after the reaction gas is supplied to the wafer 200, the adsorption inhibition gas may also be supplied to the wafer 200. That is, the wafer 200 may be post-treated by using the adsorption inhibition gas. The adsorption inhibition gas is an example of a halogen element-containing gas.
S1: (Precursor gas → Reaction gas -> P + Adsorption inhibition gas -> V) × n
S2: (Precursor gas → Reaction gas -> (P + Adsorption inhibition gas -> V → Adsorption inhibition gas) × c) × n
S3: (Precursor gas -> Reaction gas -> P -> V + Adsorption inhibition gas) × n
S4: (Precursor gas → Reaction gas → (P/V) × c -> Adsorption inhibition gas -> (P/V) × d) × n
S5: (Precursor gas → Reaction gas → Adsorption inhibition gas -> (P/V) × c) × n

Where, n, c, and d are natural numbers (integers of 1 or 2 or more). Further, n, c, and d may be the same natural number or different natural numbers. Further, in these film-forming sequences, the control of the exposure amount of the above-described embodiments may not be applied. Further, in these film-forming sequences, before the precursor gas is supplied, the adsorption inhibition gas may not be supplied. Even without performing these steps, at least one of the effects to be described below may be achieved.

Note that "P" means purging. That is, the controller 121 opens the valves 512, 524, and 534 to supply an inert gas such as a N₂ gas into the process chamber 201 via the gas supply pipes 310, 320, and 330 and the nozzles 410, 420, and 430. The inert gas such as the N₂ gas supplied into the process chamber 201 is exhausted via the exhaust pipe 231. Further, "P + adsorption inhibition gas" means that supply of the adsorption inhibition gas into the process chamber 201 (the first step) and purging are performed simultaneously.

"V" means the above-described residual gas removal (the second step). Further, "V + adsorption inhibition gas" means that residual gas removal (the second step) and supply of the adsorption inhibition gas into the process chamber 201 are performed simultaneously. Further, "(P/V) × c" means that purging and residual gas removal (the second step) are performed c times. Note that residual gas removal (the fourth step, the sixth step) may be performed after the "precursor gas" supplying step and the "reaction gas" supplying step, respectively.

Herein, when the reaction gas is adsorbed on a specific site on the wafer 200, in the next cycle, the precursor gas is adsorbed to the reaction gas adsorbed on the specific site on the wafer 200, making it easier for a CVD-like reaction to occur. As a result, the film thickness of the specific site on the wafer 200 may increase, which may deteriorate the step coverage of the wafer 200. In particular, such an issue is likely to occur when the molecules of the reaction gas are multiple-adsorbed on the specific site on the wafer 200.

As a countermeasure for this, in this modification, as in the above-described film-forming sequences (S1 to S5), the adsorption inhibition gas is supplied into the process chamber 201 after the reaction gas is supplied into the process chamber 201. As a result, the reaction gas adsorbed on the specific site on the wafer 200 reacts with the adsorption inhibition gas to produce a reaction product. That is, the reaction gas adsorbed on the specific site on the wafer 200 may be desorbed as a reaction product from the specific site on the wafer 200. Therefore, since the amount of adsorption of the reaction gas on the specific site on the wafer 200 is reduced, the CVD-like reaction (vapor phase reaction) on the wafer 200 may be suppressed. As a result, deterioration of the step coverage of the wafer 200 may be suppressed. That is, the step coverage may be improved. Further, since the adsorption inhibition gas is adsorbed on the specific site on the wafer 200 from which the reaction gas is desorbed, the adsorption of the precursor gas on the specific site is suppressed in the next cycle. Therefore, the step coverage of the wafer 200 may be further improved.

Further, as in the above-described film-forming sequences (S1 and S2), by simultaneously performing the supply of the adsorption inhibition gas into the process chamber 201 and the purging (P), the effect of removing the reaction gas remaining in the process chamber 201 and a gas containing the produced reaction product from the process chamber 201 may be enhanced.

Further, in the above-described film-forming sequences (S1 and S2), after the adsorption inhibition gas is supplied into the process chamber 201, residual gas removal (the second step) is performed to remove the adsorption inhibition gas, etc. from the process chamber 201. As a result, the reaction gas remaining in the process chamber 201 and the gas containing the produced reaction product may be removed from the process chamber 201. Thereafter, the adsorption inhibition gas may be supplied into the process chamber 201 as in the above-described film-forming sequence (S2). As a result, since the adsorption inhibition gas is adsorbed on the specific site on the wafer 200 from which the reaction gas is desorbed, the adsorption of the precursor gas on the specific site is further suppressed in the next cycle. In other words, it is possible to obtain an effect of filling sites where the molecules of the precursor gas are adsorbed on the wafer 200 with the adsorption inhibition gas.

Further, as in the above-described film-forming sequence (S2), by performing (P + adsorption inhibition gas -> V -> adsorption inhibition gas) a predetermined number of times (c times, where c is an integer of 1 or 2 or more), the amount of adsorption of the reaction gas adsorbed on the specific site on the wafer 200 may be further reduced, and the adsorption inhibition gas may be further adsorbed on the specific site on the wafer 200 from which the reaction gas is desorbed.

Further, as in the above-described film-forming sequence (S3), after the adsorption inhibition gas is supplied into the process chamber 201, when residual gas removal (the second step) is performed, the adsorption inhibition gas may be supplied into the process chamber 201. In other words, by simultaneously performing the second step (residual gas removal) and the supply of the adsorption inhibition gas into the process chamber 201, the adsorption inhibition gas may be supplied into the process chamber 201 in a state where the internal pressure of the process chamber 201 is lowered. As a result, the adsorption inhibition gas may be more uniformly adsorbed on the wafer 200.

Further, as in the above-described film-forming sequences (S4 and S5), by performing the purging and residual gas removal (the second step) a predetermined number of times (once or more) before and after the step of supplying the adsorption inhibition gas into the process chamber 201, the amount of adsorption of the reaction gas adsorbed on the specific site on the wafer 200 may be further reduced. Therefore, the step coverage of the wafer 200 may be improved.

Further, in the film-forming sequences (S1, S2, S3, S4, S5, etc.), for example, when a NH₃ gas is used as the reaction gas and a HCl gas is used as the adsorption inhibition gas, for example, at least one selected from the group of ammonium chloride (NH₄Cl), N₂, H₂, etc. is produced as the reaction product. However, the present disclosure is not limited thereto. For example, the gases described in the present disclosure may be used as each gas. The reaction product becomes a substance produced by the reaction of the gas used.

By supplying the adsorption inhibition gas in the film-forming sequences (S 1, S2, S3, S4, S5, etc.), the number of reaction gas molecules multiple-adsorbed on the wafer 200 may be reduced. In this way, the adsorption inhibition gas suppresses the molecules of the precursor gas from being adsorbed on the wafer 200 and promotes the desorption of the reaction gas from the wafer 200. In other words, the surface condition of the wafer 200 is modified. Therefore, the adsorption inhibition gas used herein, that is, the gas used in post-treatment (adsorption inhibition gas), is also referred to as an post-process gas, a post-treatment gas, a treatment gas, a modifying gas, or a desorption-promoting gas. Further, since the surface condition (surface characteristic, adsorption characteristic) of the wafer 200 is changed, the adsorption inhibition gas before the supply of the precursor gas according to the present disclosure may also be referred to as a pre-process gas, a pre-treatment gas, a treatment gas, or a modifying gas.

Further, for example, in the above-described embodiments, the case where the gas containing the Si element is used as the precursor gas is described as an example, but the present disclosure is not limited thereto. For example, there is a case that can also be applied to a process in which a gas containing at least one selected from the group of a Group XIII element, a Group XIV element, a Group IV element, a Group VI element, and a Group VIII element is used for the precursor gas.

Further, in the above-described embodiments, the case where the gas containing the nitrogen element is used as the reaction gas is described as an example, but the present disclosure is not limited thereto. For example, by using a gas containing an oxygen element as the reaction gas, an oxide film may be formed on the wafer 200. The gas containing an oxygen element includes an oxygen (O₂) gas, water (H₂O), a hydrogen peroxide (H₂O₂) gas, a nitrous oxide (dinitrogen monoxide) (N₂O) gas, a nitrogen monoxide (NO) gas, an ozone (O₃) gas, etc. Further, a gas obtained by activating or exciting one or more of these gases may be used as the reaction gas.

Further, by using a gas containing a hydrogen element as the reaction gas, a film containing the hydrogen element as a main component may be formed on the wafer 200. The gas containing a hydrogen element includes, for example, a gas composed of a hydrogen element, such as a hydrogen (H₂) gas or a deuterium gas, and a mononuclear matrix hydride gas such as a silane-based gas, a borane-based gas, a phosphane-based gas, or a germane-based gas. Further, a gas obtained by activating or exciting one or more of these gases may be used as the reaction gas. Further, the silane-based gas includes a monosilane (SiH₄) gas, a disilane (Si₂H₆) gas, a trisilane (Si₃H₈) gas, etc. The borane-based gas includes a monoborane (BH₃) gas, a diborane (B₂H₆) gas, etc. The phosphane-based gas includes a phosphine (PH₃) gas, a diphosphine (P₂H₆) gas, etc. The germane-based gas includes a monogermane (GeH₄) gas, a digermane (Ge₂H₆) gas, a trigermane (Ge₃H₈) gas.

Further, in the above-described embodiments, an example is described in which a film is formed by using a substrate processing apparatus which is a batch-type vertical apparatus configured to process a plurality of substrates at a time. However, the present disclosure is not limited thereto, but may also be suitably applied to a case where a film is formed by using a single-wafer type substrate processing apparatus configured to process one or several substrates at a time. Even when using such a substrate processing apparatus, film formation may be performed under the same sequences and process conditions as in the above-described embodiments.

A process recipe (a program in which the processing procedure, process conditions, and the like are written) used when forming these various types of thin films may be provided individually (in plural) according to contents of substrate processing (film type, composition ratio, film quality, film thickness, processing procedure, process conditions, and the like of a thin film to be formed). Then, when starting the substrate processing, a proper process recipe may be appropriately selected from a plurality of process recipes according to the contents of the substrate processing. Specifically, the plurality of process recipes individually provided according to the contents of the substrate processing may be stored (installed) in advance in the memory 121c included in the substrate processing apparatus via a telecommunication line or a recording medium (the external memory 123) on which the process recipes are recorded. Then, when starting the substrate processing, the CPU 121a included in the substrate processing apparatus may appropriately select a proper process recipe from the plurality of process recipes stored in the memory 121c according to the contents of the substrate processing. With this configuration, it is possible to form thin films of various film types, composition ratios, film qualities, and film thicknesses with a single substrate processing apparatus in a versatile and well-reproducible manner. Further, it is possible to reduce an operator's operation burden (input burden of processing procedure, process conditions, etc.) and to quickly start the substrate processing while avoiding an operation error.

Further, the present disclosure may also be realized by, for example, changing a process recipe of the existing substrate processing apparatus. When changing a process recipe, the process recipe according to the present disclosure may be installed on the existing substrate processing apparatus via a telecommunications line or a recording medium on which the process recipe is recorded, or it is also possible to change a process recipe of the existing substrate processing apparatus to the process recipe according to the present disclosure by operating an input/output device of the existing substrate processing apparatus.

Moreover, the above-described embodiments and modifications may be used in proper combinations. The processing procedures and process conditions at this time may be the same as, for example, those of the above-described embodiments and modifications.

For example, as shown in FIGS. 6, 7, and 8, there is a region where the amount of adsorption with respect to the amount of exposure to the wafer is not saturated. This region may be used for at least one or more selected from the group of the precursor gas, the reaction gas, and the adsorption inhibition gas. Further, for example, instead of supplying the adsorption inhibition gas before supplying the precursor gas, the adsorption inhibition gas (modifying gas) may be supplied after supplying the reaction gas. Even with this configuration, one or more of the effects shown in the present disclosure may be obtained.

The embodiments of the present disclosure are specifically described above. However, the present disclosure is not limited to the above-described embodiments, and various changes may be made without departing from the gist thereof.

### EXPLANATION OF REFERENCE NUMERALS

10: substrate processing apparatus, 121: controller, 200: wafer (substrate), 201: process chamber

## Claims

1. A method of processing a substrate, comprising:
a) supplying an adsorption inhibition gas to the substrate;
b) supplying a precursor gas to the substrate;
c) supplying a reaction gas to the substrate; and
d) forming a film containing an element contained in the precursor gas on the substrate by performing a), b), and c) a predetermined number of times in a state where an amount of exposure of the precursor gas supplied in b) to the substrate is larger than an amount of exposure of the adsorption inhibition gas supplied in a) to the substrate.

2. The method of Claim 1, wherein in d), an amount of adsorption of the precursor gas supplied in b) on the substrate is larger than an amount of adsorption of the adsorption inhibition gas supplied in a) on the substrate.

3. The method of Claim 1, wherein in d), a flow rate of the precursor gas supplied in b) is higher than a flow rate of the adsorption inhibition gas supplied in a).

4. The method of Claim 1, wherein in d), a partial pressure of the precursor gas in a space where the substrate exists in b) is higher than a partial pressure of the adsorption inhibition gas in the space where the substrate exists in a).

5. The method of Claim 1, wherein in d), a supply time of the precursor gas supplied in b) is longer than a supply time of the adsorption inhibition gas supplied in a).

6. The method of Claim 1, wherein the amount of exposure of the adsorption inhibition gas is set to be an amount at which an amount of improvement in a coverage of the film formed on the substrate in d) is saturated.

7. The method of Claim 1, wherein the amount of exposure of the adsorption inhibition gas is set to be an amount at which molecules of the adsorption inhibition gas are saturated and adsorbed on the substrate.

8. The method of Claim 1, wherein the substrate includes a recess, and
wherein the amount of exposure of the adsorption inhibition gas is set to be an amount at which molecules of the adsorption inhibition gas are saturated and adsorbed on an opening side of the recess.

9. The method of Claim 1, wherein the amount of exposure of the precursor gas is set to be an amount at which adsorption of molecules of the precursor gas on the substrate is not saturated.

10. The method of Claim 1, wherein an amount of exposure of the reaction gas is set to be an amount at which adsorption of molecules of the reaction gas on the substrate is saturated.

11. The method of Claim 1, wherein the substrate includes a recess, and
wherein the amount of exposure of the adsorption inhibition gas is set to be an amount at which step coverage of the film which is formed in the recess is 70% or more.

12. The method of Claim 1, wherein the substrate includes a recess, and
wherein the amount of exposure of the adsorption inhibition gas is set to be an amount at which a difference in step coverage of the film which is formed in the recess in a depth direction of the recess is within 20%.

13. The method of Claim 1, wherein a) includes causing at least a portion of a halogen element-containing gas to be adsorbed on the substrate so as to suppress a portion of a ligand of the precursor gas from being adsorbed on the substrate.

14. The method of Claim 1, wherein a) includes causing at least a portion of the adsorption inhibition gas to be adsorbed on the substrate so as to suppress a decomposition product of the precursor gas from being adsorbed on the substrate.

15. The method of Claim 1, wherein b) includes supplying the precursor gas stored in a storage.

16. The method of Claim 1, wherein b) includes:
b1) supplying the precursor gas stored in a storage;
b2) after b1), stopping the supply of the precursor gas; and
b3) after b2), supplying the precursor gas which is not stored in the storage.

17. The method of Claim 1, wherein b) includes supplying the precursor gas via two nozzles.

18. The method of Claim 1, wherein a) is performed before b).

19. The method of Claim 1, wherein a) is performed after c).

20. The method of Claim 19, wherein after c), a) is performed while purging a space where the substrate exists.

21. The method of Claim 20, wherein after performing a) after c), the space is exhausted.

22. The method of Claim 21, wherein after the exhaust of the space after c), a) is further performed.

23. The method of Claim 22, wherein after c), performing a) while purging the space, exhausting the space after a) and further performing a) after the exhaust of the space are performed a predetermined number of times.

24. The method of Claim 19, wherein after c), after purging a space where the substrate exists, a) is performed while exhausting the space.

25. The method of Claim 19, wherein after performing a) after c), purge and exhaust of a space where the substrate exists are repeated.

26. The method of Claim 25, wherein between c) and a), the purge and the exhaust of the space where the substrate exists are repeated.

27. A method of manufacturing a semiconductor device, comprising:
a) supplying an adsorption inhibition gas to a substrate;
b) supplying a precursor gas to the substrate;
c) supplying a reaction gas to the substrate; and
d) forming a film containing an element contained in the precursor gas on the substrate by performing a), b), and c) a predetermined number of times in a state where an amount of exposure of the precursor gas supplied in b) to the substrate is larger than an amount of exposure of the adsorption inhibition gas supplied in a) to the substrate..

28. A program that causes, by a computer, a substrate processing apparatus to perform a process comprising:
a) supplying an adsorption inhibition gas to a substrate;
b) supplying a precursor gas to the substrate;
c) supplying a reaction gas to the substrate; and
d) forming a film containing an element contained in the precursor gas on the substrate by causing an amount of exposure of the precursor gas supplied in b) to the substrate to be larger than an amount of exposure of the adsorption inhibition gas supplied in a) to the substrate and performing a), b), and c) a predetermined number of times.

29. A substrate processing apparatus comprising:
a process container configured to accommodate a substrate;
a first gas supply system configured to supply a precursor gas to the process container;
a second gas supply system configured to supply an adsorption inhibition gas to the process container;
a third gas supply system configured to supply a reaction gas to the process container; and
a controller configured to be capable of controlling the first gas supply system, the second gas supply system, and the third gas supply system to perform the method of Claim 1.
